# EUROPÄISCHE PATENTANMELDUNG

(11) **EP 2 105 978 A1**
(43) Veröffentlichungstag der Anmeldung: **30.09.2009**
(21) Anmeldenummer: 09155116.8
(22) Anmeldetag: 13.03.2009
(51) Int. Cl.: H01L 39/24

(54) **Hochtemperatursupraleiter-Schichtanordnung**

(30) Priorität: 29.03.2008 DE 102008016257
(71) Anmelder: Zenergy Power GmbH, 53359 Rheinbach (DE)
(72) Erfinder: Bäcker, Michael, 50670 Köln (DE); Brunkahl, Oliver, 53424 Remagen (DE)
(74) Vertreter: Lippert, Stachow & Partner

(57) **Zusammenfassung**

Die Erfindung betrifft eine Hochtemperatursupraleiter-Schichtanordnung umfassend ein Trägermaterial und eine texturierte Pufferschicht aus oxidischen Material, die ein texturiertes Aufwachsen eines Hochtemperatursupraleiters ermöglicht. Überraschenderweise kann durch eine Schicht des Puffermaterials aus einem Seltenerdenmetall-Cer-Oxid, enthaltend Lanthan als Seltenerdenmetall, eine homogene Pufferschicht in gegebenenfalls nur einem Beschichtungsvorgang erzeugt werden. In dem Pufferschichtmaterial können ein Seltenerdenmetall und/oder Cer teilweise durch Übergangsmetalle substituiert sein.

## Beschreibung

Die Erfindung betrifft eine Hochtemperatursupraleiter-Schichtanordnung umfassend mindestens ein Trägermaterial und eine texturierte Pufferschicht, die ein texturiertes Aufwachsen einer Hochtemperatursupraleiter(HTSL)-Schicht ermöglicht.

Die Pufferschicht hat eine Vielzahl unterschiedlicher Funktionen. Zum Einen soll diese die Textur von dem einen möglichst hohen Texturgrad aufweisenden texturierten Trägermaterial möglichst vollständig und perfekt auf die aufzuwachsende HTSL-Schicht übertragen. Hierbei ist zu berücksichtigen, dass das Trägermaterial möglichst weitgehend biaxial texturiert ist, d.h. sowohl senkrecht zu der Schicht als auch in einer axialen Richtung innerhalb der Schicht. Eine entsprechende biaxiale Texturierung des Hochtemperatursupraleiters ist zur Erzielung hoher kritischer Ströme und hoher Stromdichten notwendig. Weiterhin soll die Pufferschicht eine Diffusion von Bestandteilen oder Verunreinigungen des Trägermaterials in die HTSL-Schicht wirksam verhindern, da hierdurch die kritische Stromdichte und/oder der absolute kritische Strom des Hochtemperatursupraleiters vermindert oder der supraleitende Zustand gestört werden kann. Weiterhin soll die Pufferschicht eine möglichst hohe Haftfestigkeit sowohl mit dem Trägermaterial als auch mit dem aufzuwachsenden Hochtemperatursupraleiter aufweisen. Weiterhin muss die Pufferschicht ausreichende mechanische und Temperaturwechseleigenschaften aufweisen, sowohl unter Herstellungs- als auch Einsatzbedingungen. Zudem soll die Pufferschicht möglichst einfach, reproduzierbar und mit hoher Prozeßgeschwindigkeit herstellbar sein.

Ferner soll das Pufferschichtmaterial auch ein gutes Aufwachsverhalten auf das Trägermaterial aufweisen, welches ein Metall oder eine Metalllegierung darstellen kann. Das Aufwachsverhalten ist unter anderem für die Qualität des Texturübertrages, die Haftfestigkeit der aufwachsenden Schicht auf dem Substrat aber auch der Homogenität der aufwachsenden Schicht von Bedeutung, die möglichst frei von Mikrorissen, Poren oder anderen Strukturdefekten und frei von Fremdphasen, beispielsweise amorphen Phasen aufgrund mangelnder Kristallisation, Ausscheidungsphasen, Produkten chemischer Nebenreaktionen und dergleichen sein soll. Weiterhin ist die Pufferschicht ihrerseits entscheidend für das Aufwachsverhalten der HTSL-Schicht, wobei wiederum die oben genannten Probleme zu berücksichtigen sind.

Als Pufferschichtmaterial werden bisher eine Reihe unterschiedlicher Materialien eingesetzt, wie beispielsweise Yttriumstabilisiertes Zirkonoxid (YSZ), verschiedene Zirkonate wie Gadoliniumzirkonat, Lanthanzirkonat oder dergleichen, Titanate wie Strontiumtitanat, einfache Oxide wie Ceroxid, Magnesiumoxid oder dergleichen. Um das heutzutage bestehende komplexe und hohe Anforderungsprofil zu erfüllen, insbesondere einen hohen Texturübertrag und hohe Diffusionsbarriere zu gewährleisten, besteht die Pufferschicht aus Schichtkombinationen mehrerer unterschiedlicher Puffermaterialien, teilweise aus fünf oder mehr Schichten.

So hat es sich beispielsweise herausgestellt, dass Ceroxid (CeO₂) als Substrat für die aufzuwachsende HTSL-Schicht gut geeignet ist, andererseits bildet Ceroxid nur eine schlechte Diffusionsbarriere und ist somit für ein Aufwachsen unmittelbar auf ein metallisches Trägermaterial wenig geeignet. Weiterhin hat es sich herausgestellt, dass für eine ausreichend gute und schnelle Kristallisation von Ceroxid bei dem Kristallisationsschritt eine zu stark reduzierende Atmosphäre wie z.B. Formiergas (beispielsweise mit ca. 2-5 Vol.-% H2) nicht geeignet ist. Die Verwendung einer Atmosphäre aus reinem Stickstoff hat sich jedoch aufgrund der stets in diesem vorhandenen Spuren von Restsauerstoff im ppm-Bereich bei metallischen Trägermaterialien als nicht geeignet herausgestellt, da diese zur Oxidbildung führen, beispielsweise im Falle von Wolfram-dotierten Nickelbändern zur Bildung von hochstabilen und unerwünschten Nickelwolframoxiden. Zur Herstellung heutiger HTSL-Schichtanordnungen werden daher im Allgemeinen Pufferschichten mit einer Mehrzahl unterschiedlicher Einzelschichten aus verschiedenen Materialien eingesetzt.

Die Aufbringung mehrerer Schichten von Puffermaterial ist jedoch verfahrenstechnisch überaus aufwändig und reduziert die Produktionsgeschwindigkeit des Gesamtherstellungsverfahrens einer funktionsfähigen HTSL-Schichtanordnung beträchtlich, da nach jedem Schichtauftrag eines Puffermaterials eine Glühbehandlung notwendig ist, bevor ein weiterer Auftrag durch chemische Lösungsbeschichtung (CSD) erfolgen kann. So werden die Herstellungskosten der HTSL-Schichtanordnung wesentlich durch die Bildung der Pufferschicht mitbestimmt. Durch die Verwendung einer einschichtigen Pufferschicht herkömmlicher Materialien kann das komplexe Anforderungsprofil jedoch nur unzulänglich erfüllt werden.

Weiterhin besteht ein Bedürfnis, die Qualität der Hochtemperatursupraleiter-Schichten im Hinblick auf deren Homogenität und Textur weiter zu erhöhen. Es versteht sich jedoch, dass hier anderseits die Aufbringung einer Vielzahl von Pufferschichten kontraproduktiv ist, da das stets neue Aufwachsen zu den oben genannten Aufwachs- und Kristallisationsproblemen führt, die letztlich auch die Homogenität der HTSL-Schicht negativ beeinflussen, und hierdurch auch der Texturübertrag von der Trägermaterialschicht auf die HTSL-Schicht verschlechtert wird.

Die oben genannten Anforderungen sollen nach Möglichkeit insbesondere auch bei einer HTSL-Schichtanordnung erfüllt werden, bei welcher die Pufferschicht und/oder die HTSL-Schicht mittels chemischer Lösungsbeschichtungen herstellbar sind. Aufgrund der hiermit verbundenen Vorgänge bei thermischen Bildung der Puffer- und HTSL-Schicht sind auch an die Erzeugung dieser Schichten besondere Anforderungen zu stellen. Insbesondere unterscheidet sich die Kinetik der Schichtbildung und Kristallisation grundlegend von den Erfordernissen an eine Erzeugung dieser Schichten durch physikalische Verfahren wie Pulsed-LaserDeposition (PLD), thermische Coverdampfung (TCE), metallorganischer Gasphasenabscheidung (MOCVD) oder dergleichen.

Der Erfindung liegt die Aufgabe zugrunde, eine Hochtemperatursupraleiter-Schichtanordnung bereitzustellen, die einerseits ein gutes Aufwachsverhalten auf das Trägermaterials aufweist, die aus möglichst wenig Einzelschichten bestehen kann und welche ein einfaches und möglichst fehlerfreies Aufwachsen der HTSL-Schicht ermöglicht.

Diese Aufgabe wird durch die HTSL-Schichtanordnung nach Anspruch 1 gelöst, bei welcher zumindest eine Schicht des Puffermaterials aus einem Seltenerdenmetall-Cer-Oxid besteht. Überraschenderweise liegt hiermit eine Schicht mit guten Diffusionsbarriereeigenschaften vor, die ein gutes Aufwachsverhalten sowohl auf das Trägermaterial aufweist als auch ein gutes Aufwachsen des HTSL-Materials auf diese bei hohem Texturübertrag aufweist und die ohne unerwünschte Fremdphasen herstellbar ist. Hierdurch ist es möglich, sehr hohen Anforderungen genügende HTSL-Schichtanordnungen mit nur einer Pufferschicht zu erzeugen, die zudem durch chemische Lösungsbeschichtung herstellbar ist. Ferner ist die Pufferschicht auch mit relativ hohen Schichtdicken in hoher Qualität herstellbar.

Bevorzugte Weiterbildungen ergeben sich aus den Unteransprüchen.

Das Seltenerdenmetall und/oder Cer können teilweise substituiert sein. Die Substitution kann im Hinblick auf einzelne Lagen vollständig unter Bildung stöchiometrischer (geordneter) Abwandlungen oder unter Bildung nicht-stöchiometrischer (homogener) Mischkristallphasen erfolgen.

Das Seltenerdenmetall-Cer-Oxid kann ein binäres oder multinäres Oxid sein, welches auch weitere Komponenten aufweisen und beispielsweise ein Hauptgruppenmetall-Seltenerdenmetall-Cer-Oxid, ein Übergangsmetall-Seltenerdenmetall-Cer-Oxid oder Mischformen zwischen diesen sein kann, wie ein Hauptgruppenmetall-Übergangsmetall-Seltenerdenmetall-Cer-Oxid. Vorzugsweise weist das Seltenerdenmetall-Cer-Oxid als Metalle ausschließlich Seltenerdenmetalle auf.

Das Seltenerdenmetall-Cer-Oxid kann zwei oder mehr unterschiedliche Seltenerdenmetalle (außer Cer) aufweisen, wobei (Seltenerdenmetall-Seltenerdenmetall)-Cer-Oxide, Seltenerdenmetall-(Cer-Seltenerdenmetall)-Oxide oder (Seltenerdenmetall-Seltenerdenmetall)-(Cer-Seltenerdenmetall)-Oxide als homogene Mischkristallphasen auftreten können, bei denen somit das Seltenerdenmetall und/oder Cer unabhängig voneinander durch andere Seltenerdenmetalle substituiert sein können. In den oben genannten Verbindungen kann das Seltenerdenmetall eines oder mehrere Metalle sein ausgewählt aus der Gruppe La, Nd, Sm, Eu, Gd, Y und Yb, insbesondere La, Sm, Eu, Gd. Besonders bevorzugt ist das Seltenerdenmetall vollständig La oder La ist als Seltenerdenmetall enthalten.

Die Seltenerdenmetalle und/oder Cer können teilweise durch andere Übergangsmetalle, z.B. Übergangsmetalle der ersten, zweiten und/oder dritten Nebengruppe, insbesondere durch Metalle der zweiten und/oder dritten Nebengruppe substituiert sein, insbesondere eines oder mehrere der Metalle aus der Gruppe Hf, Zr, Ta, Nb, insbesondere Zr oder Hf. Gegebenenfalls können die Seltenerdenmetalle und/oder Übergangsmetalle der oben genannten Oxide, gegebenenfalls auch Cer, auch unabhängig voneinander teilweise durch Hauptgruppenmetalle ersetzt sein, beispielsweise durch eines oder mehrere Metalle aus der Gruppe von Alkalimetallen, Erdalkalimetallen, Metallen der dritten Hauptgruppe oder mit Metallen oder Halbmetallen der vierten oder fünften Hauptgruppe, beispielsweise Rb, Cs, Sr, Ba, Ga, In, Tl, Sn, Pb, Bi, As, Sb, Se oder Te.

Das Seltenerdenmetall-Cer-Oxid kann die allgemeine Formel RE₂₊ₓCe_{2+y}O_{z} mit -2 < x, y < 2, vorzugsweise -1 ≤ x, y ≤ 1 oder -0,5 ≤ x, y ≤ 0,5 aufweisen. Vorzugsweise gilt, wenn x ≤ 0 ist y ≥ 0 und wenn y ≤ 0 ist x ≥ 0. Vorzugsweise ist jeweils x = - y. x, y können unabhängig voneinander 0 sein. Es kann sein x + y = ± ∂, wobei ∂ ≤ 0,5 bis 1, vorzugsweise ≤ 0,2 bis 0,3 oder ≤ 0,15 bis 0,1 sein kann. Ist ∂ kleiner 0, so kann das Kationenteilgitter Leerstellen aufweisen, ist ∂ größer 0, so können interstitielle Lagen wie z.B. Oktaederlücken zusätzlich besetzt sein. Insbesondere kann ∂ gleich 0 sein. RE ist eines oder mehrere Seltenerdenmetalle der Gruppe La, Y, Ce, Pr, Nd, Pm, Sm, Eu, Gd, Tb, Dy, Ho, Er, Tm, Yb, Lu sein, insbesondere nur aus der Gruppe La und Ln (Ce, Pr, Nd, Pm, Sm, Eu, Gd, Tb, Dy, Ho, Er, Tm, Yb, Lu) oder nur aus der Gruppe Ln. Insbesondere kann Ln jeweils eines oder mehrere Metalle aus der Gruppe Ce, Nd, Sm, Eu, Gd, Yb sein. z hat einen Wert, der die neutrale Ladungsbilanz sicherstellt, gegebenenfalls kann gelten 5 ≤ z ≤ 8 oder 7 ≤ z ≤ 8, insbesondere z = 7.

Das Pufferschichtmaterial kann ein Seltenerdenoxid der allgemeinen Formel RE₂₋ₓCe_{2-y}O_{7±2z} oder RE₂₋ₓCe_{2-y}O_{7±z}, jeweils mit 0 ≤x, y, z ≤ 1 sein, wobei RE eines oder mehrere Seltenerdenmetalle sind und wobei RE und/oder Ce teilweise substituiert sein können. RE und/oder Ce können unabhängig voneinander teilweise gegen ein Metall M substituiert sein, welches eines oder mehrere Metalle ist ausgewählt aus der Gruppe der Übergangsmetalle (ausgenommen Seltenerdenmetalle) und Hauptgruppenmetalle, einschließlich Zn. M kann jeweils ein oder mehrere Metalle der Übergangsmetalle der ersten, zweiten und/oder dritten Nebengruppe sein, vorzugsweise der zweiten und/oder dritten Nebengruppe, jeweils ausgenommen der Lanthanoiden und Actinoiden. Vorzugsweise ist M ein oder mehrere Metalle mit einer Wertigkeit von zwei bis fünf oder von drei bis fünf, insbesondere von drei bis vier oder von vier bis fünf. Sind M mehrere Metalle, so haben diese vorzugsweise dieselbe Wertigkeit, vorzugsweise 3, 4 oder 5. So kann M jeweils eines oder mehrere Metall aus der Gruppe Sr, Ba, Ga, In, Tl, Sn, Pb, Bi, oder auch As, Sb, Se oder Te oder Tantal, Niob, Hafnium, Zirkon. Insbesondere kann M eines oder mehrere Metalle aus der Gruppe Hafnium, Zirkon, Tantal, Niob sein. In einer Formel RE₂₊ₓCe_{2+y}MᵥO_{z} kann sein -2 ≤ x, y, v ≤2, vorzugsweise -1 ≤ , y, v ≤ 1 oder -0,5 ≤ x, y, v ≤ 0,5. Vorzugsweise ist hierbei x + y + v = ± ∂, wobei ∂ ≤ 0,5 bis 1, vorzugsweise ≤ 0,2 bis 0,3 oder ≤ 0,15 bis 0,1 oder 0 sei kann. Insbesondere kann y = -v sein, wobei unabhängig oder zugleich x = 0 sein kann. Entsprechendes kann auch bei einer Formel RE₂₊ₓMᵥCe_{2+y}O_{z} gelten, wobei x = -v und sein kann und unabhängig oder zugleich y = 0 sein kann. RE kann wie oben angegeben ausgewählt sein, insbesondere La und/oder Y. z hat einen Wert, der die neutrale Ladungsbilanz sicherstellt, gegebenenfalls kann gelten 5 ≤ z ≤ 8 oder 7 ≤ z ≤ 8, insbesondere z = 7.

Das Seltenerdenmetall-Cer-Oxid kann auch die allgemeine Formel Ln'₂₋ₓLn''ₓCe_{2-y}MᵥO_{z}, mit 0 ≤ x, y, v ≤ 2, vorzugsweise 0 ≤ x, y, v ≤ 1, aufweisen, wobei z zwischen 5 und 8 betragen kann, vorzugsweise 6-8, und wobei Ln', Ln'' unabhängig voneinander ein Seltenerdenmetall und M wie oben definiert ist. Es kann sein v = y. M kann insbesondere ein vierwertiges Metall sein. Ln ist hierbei ein Lanthanid, wie beispielsweise Nd, Sm, Eu, Gd, Tb, Er, Yb oder Lu, ausgenommen Ce. M kann ausgewählt sein wie oben angegeben, beispielsweise ein Metall der zweiten oder dritten Nebengruppe, einschließlich Kombinationen derselben. M kann Hf, Zr, Ta, Nb sein, einschließlich Kombinationen derselben. Insbesondere kann y jedoch auch gleich 0 sein. z hat einen Wert, der die neutrale Ladungsbilanz sicherstellt, gegebenenfalls kann gelten 5 ≤ z ≤ 8 oder 7 ≤ z ≤ 8, insbesondere z = 7.

Insbesondere kann das Seltenerdenmetall-Cer-Oxid die allgemeine Formel (La, Ln) ₂Ce₂O_{7±z} (insbesondere mit Ln = Nd, Sm, Eu, Gd, Yb, einschließlich Kombinationen derselben) aufweisen, wobei La teilweise oder vollständig gegen Y substituiert sein kann.

Das Seltenerdenmetall-Cer-Oxid (einschließlich der oben genannten Abwandlungen) kann bezogen auf den Gesamtmetallgehalt ≥ 5-10 at.-% oder ≥ 15 at.-% Ce enthalten, vorzugsweise ≥ 20-30 at.-% oder ≥ 40-50 at.-% Cer. Der Cer-Gehalt kann bezogen auf den Gesamtmetallgehalt ≤ 95 at.-% oder ≤ 80-90 at.-%, oder ≤ 60-70 at.-% betragen, gegebenenfalls auch ≤ 40-50 at.-% oder ≤ 30 at.-%, jeweils bezogen auf den Gesamtmetallgehalt.

Der Gehalt der von Cer verschiedenen Seltenerdenmetalle RE, insbesondere auch der Gehalt von La, kann bezogen auf den Gesamtmetallgehalt zwischen 90 at.-% und 10 at.-% betragen, wobei ein, zwei oder mehr Seltenerdenmetalle vorliegen können. Der Seltenerdenmetallgehalt (außer Ce), insbesondere auch der Gehalt von La, kann bezogen auf den Gesamtmetallgehalt ≤ 95 at.-% oder ≤ 80-90 at.-%, oder ≤ 60-70 at.-% betragen, gegebenenfalls auch ≤ 40-50 at.-% oder ≤ 30 at.-%, jeweils bezogen auf den Gesamtmetallgehalt. Der Seltenerdenmetallgehalt (außer Ce), insbesondere auch der Gehalt von La, kann bezogen auf den Gesamtmetallgehalt allgemein ≥ 5-10 at.-% oder ≥ 15 at.-% Ce betragen, vorzugsweise ≥ 20-30 at.-% oder ≥ 40-50 at.-%. Liegen neben Lanthan auch andere Seltenerdenmetalle (außer Cer) vor, so kann das Verhältnis La : RE(außer Ce) im Bereich von 1:10 bis 10:1 liegen, insbesondere im Bereich von 1:5 bis 5:1 oder 1:4 bis 4:1, vorzugsweise im Bereich von 1:3 bis 3:1 oder 1:2 bis 2:1, besonders bevorzugt im Bereich von 2:3 bis 3:2 oder ca. 1 : 1, betragen, ohne hierauf beschränkt zu sein. Vorzugsweise ist der Gehalt (at.-%) an La jeweils größer als der anderer Seltenerdenmetalle (außer Ce).

Das Atomverhältnis Ce : Seltenerdenmetall (ungleich Ce), insbesondere auch das Atomverhältnis Ce : La, kann im Bereich von 1:10 bis 10:1 liegen, insbesondere im Bereich von 1:5 bis 5:1 oder 1:4 bis 4:1, vorzugsweise im Bereich von 1:3 bis 3:1 oder 1:2 bis 2:1, besonders bevorzugt im Bereich von 2:3 bis 3:2 oder ca. 1 : 1.

Insgesamt kann der Seltenerdenmetallgehalt einschließlich Cer ≥ 20-30 at.-%, ≥ 40-50 at.-% oder ≥ 60-70 at.-% bzw. ≥ 80-90 at.-%, gegebenenfalls ≥ 95 bis etwa 100 at.-%, bezogen auf den Gesamtmetallgehalt betragen.

Das Pufferschichtmaterial kann allgemein im Hinblick auf Sauerstoff eine Phasenbreite aufweisen, beispielsweise kann in den oben genannten Verbindungen (bezogen auf eine idealisierte Formel RE₂₊ₓCe₂₊ₓO_{7±z} unter Berücksichtigung der oben genannten Varianten, insbesondere der Formel (La, Ln)₂Ce₂O_{7±z}) z zwischen 0 und 1 variieren, gegebenenfalls kann das Sauerstoffgitter auch unterstöchiometrisch sein und Gitterfehlstellen aufweisen, d.h. z kann kleiner 0 sein, vorzugsweise jedoch nicht kleiner -1 (bezogen auf eine Stöchiometrie des Sauerstoffteilgitters von O_{7+z}) .

Das Seltenerdenmetall-Cer-Oxid kann beispielsweise im NaCl-, Fluorit-, Pyrochlor-, im Perowskittyp oder im GdFeO3-Typ kristallisieren, gegebenenfalls einschließlich geordneter Überstrukturen derselben. Vorzugsweise kristallisiert das Pufferschichtmaterial im Fluorittyp, im Pyrochlortyp oder gegebenenfalls einer andere Fluoritüberstruktur, wodurch die Phasenbildung und/oder Kristallisation beim Glühprozess schneller erfolgen und Schichten mit besseren Eigenschaften erhalten werden können. Es versteht sich, dass der Gehalt des weiteren Bestandteils derart ausgewählt sein kann, dass eine optimale Anpassung der Gitterkonstanten des Pufferschichtmaterials an die des Trägermaterials und/oder des HTSL-Materials bezogen auf die Gitterkonstanten in der Schichtebene der Schichtenanordnung liegen kann, gegebenenfalls unter Berücksichtigung von Überstrukturen. So können die Gitterkonstanten des Pufferschichtmaterials zumindest in etwa in den mittleren Bereich der Gitterkonstanten des Trägermaterials und der HTSL-Schicht liegen, beispielsweise mit Abweichung von ≤ ± 5-8 % oder ≤ 2-3 % oder ≤ 0,75-1 %, jeweils bezogen auf den mittleren Absolutwert der Gitterkonstanten des Trägermaterials und des HTSL-Materials in der Hauptebene der Schichtenanordnung, wobei im Falle von Überstrukturen entsprechendes für die auf die Elementarzelle des Trägermaterials transponierten und skalierten Gitterkonstanten des Pufferschichtmaterials gilt.

Die texturierte Pufferschicht kann mindestens einen weiteren, eine homogene Mischkristallphase bildenden Bestandteil enthalten, der ein Übergangsmetall der ersten Nebengruppe ist und/oder der bei einer Glühtemperatur von ≤ 1.600 Grad Celsius mit dem vorzugsweise oxidischen Puffermaterial zumindest eine partielle Schmelze bildet. Durch den weiteren, mit dem Pufferschichtmaterial eine homogene Mischkristallphase (Mischkristallphase) bildenden Bestandteil kann eine Pufferschicht erzeugt werden, die eine sehr geringe oder praktisch keine Porosität und zudem eine nur sehr geringe Rauhigkeit aufweist und die mit hoher Dichtigkeit und praktisch rissfrei herstellbar ist. Weiterhin ist eine derartige Pufferschicht durch chemische Bildungskristallisation (CSD) herstellbar. Insbesondere kann die Seltenerdenmetall-Cer-Oxid-Schicht den weiteren, eine homogene Mischkristallphase bildenden Bestandteil aufweisen.

Durch den weiteren Bestandteil kann bei der Erzeugung der Pufferschicht zumindest eine partielle Schmelze gebildet werden, so dass bei der anschließenden Glühbehandlung eine zumindest partielle Rekristallisation des Pufferschichtmaterials erfolgen kann, wobei zumindest bereichsweise intermediär eine Flüssigphase entsteht. Hierbei kann die Textur des Trägermaterials wesentlich besser als bei Verwendung des Pufferschichtmaterials ohne den weiteren Bestandteil auf die Pufferschicht und damit letztendlich auf die HTSL-Schicht übertragen werden und zudem eine Pufferschicht mit deutlich verminderter oder praktisch ohne Porosität und Mikrorissen erzeugt werden, die zudem wesentlich glatter als herkömmliche Schichten ist. Hierdurch kann die auf die Pufferschicht aufwachsende HTSL-Schicht ebenfalls sehr glatt und homogen, d.h. praktisch ohne Poren oder sonstige Bereiche sein, die wie z.B. Mikrorisse einen supraleitenden Stromdurchgang behindern. Gegebenenfalls kann auch der Texturübertrag verbessert werden. Zudem werden auch Aufwachsfehler auf die Pufferschicht, wie im Bereich von Poren herkömmlicher Pufferschichten vorliegen können und die zu HTSL-Bereichen mit anderer Kristallorientierung führen können, drastisch vermindert. Eine derartige HTSL-Schicht weist verbesserte physikalische und mechanische Eigenschaften auf, insbesondere auch im Hinblick auf die supraleitenden Eigenschaften wie kritische Stromdichte und die absolute kritische Stromstärke I_{C}, wodurch auch elektronische HTSL-Bauteile mit verbesserten Eigenschaften herstellbar sind.

Vorzugsweise ist das Trägermaterial texturiert, insbesondere biaxial texturiert, d.h. senkrecht zu der Schichtebene, auf welcher das HTSL-Materials aufgewachsen wird, und in einer Richtung innerhalb der Schichtebene, beispielsweise im Falle eines bandförmigen Trägermaterials der Bandlängsrichtung. Das Trägermaterial kann bandförmig aber auch anders dimensioniert sein, z.B. in Form von eher isometrischen Schichten. Die Pufferschicht besteht zumeist aus einem oxidkeramischen Material bzw. einem Metalloxid.

Vorzugsweise bildet der weitere Bestandteil mit dem Pufferschichtmaterial bei Temperaturen im Bereich von 1600-500°C, 1400-600°C, 1250-700°C oder 1100-800°C eine nur partielle Schmelze, so dass Fest- und Flüssigphase des Pufferschichtmaterials miteinander koexistieren, oder eine praktisch homogene bzw. vollständige Schmelze.

Insbesondere kann der weitere Bestandteil derart ausgewählt und in einem Gehalt in dem Pufferschichtmaterial vorliegen, dass dieses bei einer Glühbehandlung von ≤ 1.300 bis 1.400 Grad Celsius, vorzugsweise ≤ 1.100 bis 1.200 Grad Celsius oder ≤ 900 bis 1.000 Grad Celsius zumindest eine partielle Schmelze bildet. Es versteht sich, dass die Glühtemperatur derart zu wählen ist, dass das Pufferschichtmaterial keine unerwünschte Zersetzung oder Verflüchtigung von Bestandteilen erleidet und das Trägermaterial nicht beeinträchtigt wird, beispielsweise durch unerwünschte Phasenbildung oder nachteilige Veränderungen dessen Textur.

Der weitere Bestandteil kann in einer Konzentration in dem Pufferschichtmaterial eingesetzt werden, so dass dieses vorzugsweise bei der Glühbehandlung von ≤ 1500-1600°C aber auch der weiteren Abkühlung bis auf beispielsweise ≤ 800-900°C, ≤ 600-700°C, ≤ 400-500°C, 200-300°C oder bis auf Raumtemperatur oder tieferen Temperaturen bis ca. 70-80 Kelvin oder tiefer keine amorphen Phasen oder keine Mischphasen z.B. durch Phasenumwandlungen entstehen und die homogene Festkörpermischkristallphase auch unterhalb der Glühtemperatur langzeitbeständig ist. Die den weiteren Bestandteil enthaltende homogene Mischkristallphase kann bei Raumtemperatur und/oder der Einsatztemperatur des HTSL-Materials kinetisch langzeitbeständig sein, vorzugsweise ist sie auch thermodynamisch in dem Temperaturbereich von der Glühbehandlung (siehe oben) bis zu der Einsatztemperatur des HTSL-Materials beständig, so dass Entmischungsvorgänge oder Phasensegregationen, Ausscheidung von amorphen Phasen oder sonstigen Phasenänderungen nicht stattfinden.

Vorzugsweise ist der die homogene Mischkristallphase bildende weitere Bestandteil eines oder mehrere Metalle der ersten Nebengruppe, beispielsweise Cu, Ag, Ti, V, Cr, Mn oder Zn, besonders bevorzugt Cu und/oder Ag, oder enthält ein solches. Gegebenenfalls können auch Fe, Ni und/oder Co eingesetzt werden, diese sind jedoch aufgrund der magnetischen Eigenschaften ihrer Verbindungen nicht bevorzugt. Besonders bevorzugt sind Kupfer-und/oder Silber. Die oben genannten Übergangsmetalle können jeweils einzeln oder in Kombination eingesetzt werden, beispielsweise Kupfer in Kombination mit einem oder mehreren weiteren der oben genannten Metalle. Gegebenenfalls kann der weitere Bestandteil alternativ oder zusätzlich auch andere Metalle enthalten, beispielsweise eines oder mehrere Metalle aus der Gruppe der Hauptgruppen-Metalle wie Alkali- und/oder Erdalkalimetalle, Metalle und Halbmetalle der dritten, vierten, fünften oder sechsten Hauptgruppe, sofern diese mit dem Pufferschichtmaterial eine homogene Mischkristallphase bilden, die bei einer Glühbehandlung von ≤ 1.600°C oder den oben genannten Temperaturen zumindest eine partielle Schmelze bilden und bei niedrigeren Temperaturen, insbesondere den oben genannten Temperaturen, keinen Phasenumwandlungen oder Ausscheidungen anderer Phasen, einschließlich Bildung amorpher Phasen, unterliegen. Der weitere Bestandteil liegt vorzugsweise als Oxid vor und bildet mit dem Pufferschichtmaterial ein Mischoxid, wobei der weitere Bestandteil mittels eines Precursors eingebracht werden kann. Der weitere Bestandteil liegt vorzugsweise überwiegend oder vollständig in einer mittleren oder niedrigen Oxidationsstufe > 0 vor, z.B. in einer Oxidationsstufe von 1,2, 3 oder 4, vorzugsweise 1 bis 3 oder einer Oxidationsstufe 1 oder 2, sofern diese Oxidationsstufe ausreichend stabil ist. Insbesondere kann Kupfer als Cu(I) vorliegen.

Weiterhin sollten die weiteren Bestandteile allgemein nicht eine signifikante oder keine Tendenz zur Diffusion in die HTSL-Schicht unter (nachteiliger) Veränderung der mechanischen und/oder physikalischen Eigenschaften derselben, insbesondere Verringerung der kritischen Stromdichte und/ oder des absoluten kritischen Stroms, haben.

Der mindestens eine weitere Bestandteil oder die Kombination der weiteren Bestandteile können in einem Gehalt von bis zu 40 at.-% bezogen auf den Gesamtmetallgehalt der Pufferschicht vorliegen, gegebenenfalls auch in einem höheren Gehalt, sofern mit dem Pufferschichtmaterial eine homogene Mischkristallphase gebildet wird, die vorzugsweise auch unterhalb der Glühtemperatur beständig ist, wie oben angegeben. Der weitere Bestandteil kann in einem Gehalt von ≥ 1 bis 2 at.-% oder ≥ 3 bis 5 at.-%, vorzugsweise in einem Gehalt von ≥ 7 bis 10 at.-% vorliegen, jeweils bezogen auf den Gesamtmetallgehalt des Pufferschichtmaterials. Der Gehalt des mindestens einen oder die Kombination der weiteren Bestandteile kann ≤ 40 at.-% oder ≤ 30 bis 35 at.-%, gegebenenfalls ≤ 20 bis 25 at.-% bezogen auf den Gesamtmetallgehalt der Pufferschicht betragen.

Die Pufferschicht kann aus mehreren Einzelschichten bestehen, die sich jeweils in ihrer Zusammensetzung unterscheiden können, z.B. hinsichtlich des Pufferschichtmaterials, des Cer-Gehaltes, des Gehaltes oder der Spezies der weiteren Dotierungselemente und/oder des weiteren, eine Mischphase bildenden Bestandteils. Die einzelnen Pufferschichten können aber auch zumindest im Wesentlichen dieselbe Zusammensetzung aufweisen, z.B. um eine Pufferschicht größerer Dicke zu erzeugen.

Die den weiteren Bestandteil enthaltende Mischkristallphasen-Pufferschicht kann unmittelbar auf dem Trägermaterial aufgebracht sein kann. Es kann gegebenenfalls auch auf dem Trägermaterial auch eine Keimbildungsschicht aufgebracht sein, die aus einem oxidischen Material wie einem Titanat oder Zirkonat bestehen kann, beispielsweise aus Calciumtitanat. Diese Keimbildungschicht dient nicht als Pufferschicht sondern im Wesentlichen der Konfektionierung der Trägermaterialoberfläche. Sie besteht in der Regel aus einer Vielzahl isolierter, inselartiger Strukturen und stellt keine ausreichende Diffusionsbarriere dar.

Alternativ oder zusätzlich kann bei der aus mehreren Schichten bestehende Pufferschicht der weitere Bestandteil, der mit dem Pufferschichtmaterial eine Mischkristallphase bildet, die an die HTSL-Schicht angrenzende Schicht bilden. Die weiteren Schichten der Pufferschicht können herkömmliche Pufferschichten sein, die einen weiteren eine Mischkristallphase bildenden Bestandteil nicht aufweisen. Gegebenenfalls können auch mehrere erfindungsgemäße Puffermaterialschichten mit jeweils einem oder mehreren eine Mischphase bildenden Bestandteil vorgesehen sein, wobei in den einzelnen Schichten unterschiedliche Bestandteile oder Bestandteile in unterschiedlichen Gehalten vorliegen. Zur Ausbildung der mehrere Schichten umfassenden Puffermaterialschicht können beispielsweise die Puffermaterialien in Form von lösungsmittelhaltigen Lösungen auf das jeweilige Substrat aufgebracht werden und das Lösungsmittel teilweise oder vollständig entfernt werden. Gegebenenfalls kann sich hieran eine thermische Behandlung anschließen. Nachfolgend hierzu kann dann eine weitere Puffermaterialschicht der gleichen oder einer unterschiedlichen Zusammensetzung aufgebracht werden. Vorzugsweise erfolgt die Glühbehandlung unter Erzeugung des oxidkeramischen Puffermaterials nach Ausbildung sämtlicher Puffermaterialschichten, gegebenenfalls können nach einer Glühbehandlung auch weitere Puffermaterialschichten aufgebracht werden. Bei der nach Aufbringung der Puffermaterialschicht erfolgenden thermischen Behandlung kann das Lösungsmittel teilweise oder vollständig entfernt werden und das in Form eine Prekursors aufgebrachte Puffermaterial teilweise oder vollständig zersetzt werden.

Die erfindungsgemäße Pufferschicht kann nur einschichtig ausgebildet werden, so dass zum Beispiel im Falle einer chemischen Lösungsbeschichtung (CSD) nur durch einen einmaligen Auftrag der Lösung des Pufferschichtmaterials, so dass nach der thermischen Vorbehandlung und Glühung bereits die HTSL-Schicht aufgebracht werden kann. Gegebenenfalls kann die erfindungsgemäße Pufferschicht jedoch auch auf einer weiteren Pufferschicht aufgebracht werden, z.B. einer Schicht eines einfachen, binären oder multinären Oxids, insbesondere eines Seltenerdenoxids, z.B. auf einer Ceroxidschicht (CeO2, wobei Sauerstoff auch unterstöchiometrisch sein kann), einer Seltenerden(RE)-Seltenerden(RE)-Oxidschicht oder einer Seltenerden(RE)-Übergangsmetall(TM)schicht (z.B. einer Lanthanzirkonatschicht, Seltenerdenzirkonatschicht, Übergangsmetallceroxidschicht), die die Zusammensetzung La2Zr2O7+x, RE2Zr2O7+x oder TM2Ce2O7+x mit 0 ≤ x ≤ 1 aufweisen können, wobei diese Substratschichten den weiteren, eine homogene Mischphase bildenden Bestandteil wie Kupfer enthalten können. Die genannten Schichten können im Übrigen substituiert sein, wie auch oben zu den erfindungsgemäßen Pufferschichten ausgeführt ist und worauf hiermit Bezug genommen wird. Insbesondere können die einzelnen Pufferschichten jeweils aus demselben Material bestehen.

Das Pufferschichtmaterial kann in Form eines metallorganischen Prekursors, beispielsweise β-Diketonates, insbesondere eines Acetylacetonats, Acetats, Alkylcarboxylats oder dergleichen aufgebracht werden. Allgemein kann ein geeignetes Lösungsmittel eingesetzt werden, welches enthalten oder bestehen kann aus einem Keton, z. B. Aceton, einem oder mehreren Alkoholen, einer oder mehreren Carbonsäuren ohne hierauf beschränkt zu sein. Insbesondere können C2-C8- oder C3-C6- oder C3-C4-Carbonsäuren eingesetzt werden, die jeweils geradkettig oder verzweigt sein können, insbesondere auch Propionsäure und/oder Pivalinsäure. Die oben genannten Lösungsmitel können gegebenenfalls auch in Kombination miteinander eingesetzt werden. Das organische Lösungsmittel kann im Wesentlichen wasserfrei sein.

Besonders bevorzugt wird das Pufferschichtmaterial in Form eines Alkylcarbonats, welches 1 bis 10, vorzugsweise 2 bis 8, oder 3 bis 6 C-Atome aufweist, eingesetzt werden, beispielsweise in Form eines Propionats oder Pivalonats. Das Alkylcarbonat kann allgemein geradkettig, verzweigt oder gegebenenfalls auch zyklisch sein.

Das Pufferschichtmaterial kann auch in wässriger Lösung aufgebracht werden, als wasserlösliche Salze sind insbesondere Nitrate, Carboxylate, insbesondere Acetate, Citrate oder Tartrate, einzeln oder in Kombination, einsetzbar. Die wässrige Lösung kann auf einen pH-Wert von 4-8, vorzugsweise 5-7 oder 6-7 eingestellt sein. Vorzugsweise ist die Lösung abgepuffert, insbesondere durch einen thermisch zersetzbaren oder verflüchtigbaren Puffer, insbesondere Ammoniak oder ein Ammoniumsalz.

Die Glühbehandlung zur Kristallisation des Puffermaterials kann zumindest teilweise in einer reduzierenden Atmosphäre erfolgen, beispielsweise unter Formiergas oder einem anderen geeignetem Gas mit zumindest ähnlichem Reduktionsvermögen, wobei das Formiergas (N2/H2) 0,1 bis 15 % oder bis 20%, 0,2 bis 10 %, 0,5 bis 5 % oder 1 bis 5 %, z.B. ca. 3 % H2 enthalten kann (jeweils Volumenprozent). Die das Seltenerdenmetall-Cer-Oxid enthaltende, unmittelbar auf das Trägermaterial aufgebrachte Pufferschicht kann auch unter einer Glühbehandlung in einer nichtreduzierenden Atmosphäre, beispielsweise unter reinem Stickstoff oder einem anderen inerten Gas, hergestellt werden. Dies kann auch unter Umständen für andere oder sämtliche Pufferschichten einer mehrlagigen Puffermaterialbeschichtung gelten. Wird die das Seltenerdenmetall-Cer-Oxid enthaltende Pufferschicht auf eine zwischen dieser und dem Trägermaterial angeordnete Zwischenschicht aus Puffermaterial aufgebracht, so kann die Pufferschicht unter einer Glühbehandlung in einer reduzierenden Atmosphäre hergestellt werden, z.B. unter Formiergas, was unter Umständen auch für die Herstellung anderer oder sämtlicher der erfindungsgemäßen Pufferschichten gelten kann. Allgemein können einzelne Pufferschichten unter einer nichtreduzierenden Atmosphäre und andere Pufferschichten desselben Pufferschichtaufbaus einer HTSL-Schichtanordnung unter einer reduzierenden Atmosphäre hergestellt werden.

Die erfindungsgemäß hergestellte Pufferschicht und/oder die auf diese aufgebrachte HTSL-Schicht kann eine kritische Stromdichte von ≥ 0,5 MA/cm² aufweisen, beispielsweise im Bereich von 0,5 bis 2,5 MA/cm² oder bis 3,5 MA/cm² oder bis 4,5 MA/cm², insbesondere im Bereich von 0,5 bis 1,5 oder bis 2 MA/cm². Die kritische Stromdichte kann somit allgemein ≥ 0,75 MA/cm² oder ≥ 1 MA/cm² betragen.

Die Glühbehandlung kann derart durchgeführt werden, dass die den weiteren Bestandteil enthaltenden Pufferschicht eine Porosität von ≤ 25-30%, ≤ 15-20%, ≤ 5-10% beträgt oder die Schicht zumindest im Wesentlichen porenfrei ist.

Die Glühbehandlung kann derart durchgeführt werden, dass die den weiteren Bestandteil enthaltenden Pufferschicht eine RMS-Rauheit (root-mean-squared roughness) von ≤ 2,5-2 nm, vorzugsweise ≤ 1,6-1,8 nm oder ≤ 1,2-1,4 nm, besonders bevorzugt ≤ 1,0-0,8 nm aufweist, bestimmt über ein Areal von 1x1µm².

Der auf die Pufferschicht aufgebrachte Hochtemperatursupraleiter kann ein Seltenerdenmetall-Kupfer-Oxid, insbesondere ein Seltenerden-Erdalkalimetall-Oxid sein, wobei unabhängig voneinander das Seltenerdenmetall Yttrium und das Erdalkalimetall Barium sein können. Es versteht sich, dass insbesondere das Seltenerdenmetall z.B. Yttrium und/oder das Erdalkalimetall wie z.B. Barium teilweise gegen andere Metalle, beispielsweise durch andere Seltenerden- oder Erdalkalimetalle, substituiert sein können. Das HTSL-Material kann insbesondere ein Y-Ba-Cu-Oxid (YBa₂Cu₃Oₓ) oder ein Bi-Sr-Ca-Cu-Oxid sein. Als Hochtemperatursupraleiter im Sinne der Erfindung sei allgemein ein Supraleiter mit einer Sprungtemperatur von ≥ 77 Kelvin verstanden, gegebenenfalls allgemein aber auch ein anderer keramischer (oxidischer) Supraleiter auf der Pufferschicht aufgebracht werden.

Allgemein kann die Pufferschicht eine Dicke von 0,02 - 2 µm oder allgemein ≤ 5 µm aufweisen, ohne hierauf beschränkt zu sein, gegebenenfalls im Bereich von 0,1 - 1 µm, 0,1 - 0,5 µm oder im Bereich von 0,1 - 0,3 µm. Die Dicke des Trägermaterials ist nicht limitiert, solange dies eine ausreichende mechanische Festigkeit aufweist, sie kann im Bereich 5-1000µm, von 10-500µm, von 25-250µm oder im Bereich von 50-100µm liegen. Auf dem Trägermaterial kann vorzugsweise mit inselartiger Struktur ein das Aufwachsen der Pufferschicht förderndes Material aufgebracht sein. Die HTSL-Schicht kann, ohne hierauf beschränkt zu sein, eine Dicke von ≥ 0,05µm, insbesondere im Bereich von 0,1-50µm oder von 0,25-10µm, vorzugsweise von 0,5-5µm aufweisen.

Das Trägermaterial kann ein geeignetes Metall oder eine Legierung sein, z.B. Nickel, eine Nickellegierung wie z. B. Wolframdotiertes Nickel (beispielsweise Ni mit 5-10 at.-%W), Hastelloy oder dergleichen, gegebenenfalls kann das Trägermaterial jedoch auch ein keramisches Material sein.

Die Erfindung wir im Folgenden beispielhaft beschrieben und anhand der Ausführungsbeispiele erläutert.

Alle Beschichtungen erfolgten in einer kontinuierlichen Bandbeschichtungsanlage mit integrierter Trockenstrecke durch Tauchbeschichtung, es kann jedoch auch ein anderes Flüssigbeschichtungsverfahren eingesetzt werden, z.B. ein Druckverfahren, wie z.B. Tintenstrahl- oder Siebdruck, Sprühbeschichtungsverfahren, Beschichtungen über Kapillaren oder Schlitzdüse oder auch diskontinuierliche Beschichtungsverfahren. Die Zuggeschwindigkeit beträgt bei allen Beispielen 10m/h für ein Band mit 1cm Breite. Als Substratband wird in allen Fällen ein biaxialwalztexturiertes Ni-5at%W-Band mit 80µm Dicke verwendet. Von allen Beschichtungslösungen wurden jeweils 10ml hergestellt.

Alle Resultate sind in der Ergebnistabelle zusammengefasst.

### Beispiel 1: Lanthancerat

Aus La-und Ce-Acetat im Atomverhältnis 1:1 wird in Propionsäure eine 0,4molare Lösung (bezogen auf La) hergestellt, im Rotationsverdampfer auf die Hälfte eingedampft und wieder mit Propionsäure aufgefüllt.

Ein Metallband (Ni5%W) wird mit der Lösung unmittelbar kontinuierlich mit 10m/h tauchbeschichtet und die Schicht nach der Trocknung innerhalb von 1h bei 1000°C unter Formiergas (5%H2 in N2) kristallisiert.

### Beispiel 1a: Lanthancerat Doppelbeschichtung

Ein Teil der Beschichtung aus Beispiel 1 wurde erneut nach demselben Verfahren ein zweites Mal beschichtet, getrocknet und kristallisiert, wobei jedoch die Temperaturbehandlung unter 100% Stickstoff erfolgte.

### Beispiel 2: Lanthancerat

Cernitrat und Lanthannitrat (Metall-Verhältnis 1:1) werden in Zitronensäure in einem Verhältnis von 1:3 (Gesamtmetallionen : Zitronensäure) gelöst. Durch Zugabe von Ammoniak und Wasser wird eine 0,2molare Lösung mit einem pH-Wert von 6 hergestellt.

Die Lösung wird gemäß der allgemeinen Versuchsbeschreibung auf ein Substratband aufgebracht, auf welchem sich bereits eine doppelte Lanthanzirkonatschicht befindet. Die Trocknung erfolgt innerhalb von 30min bei 200°C unter Luft, die Glühbehandlung erfolgt innerhalb von 30min bei 900°C unter Formiergas (5%H2 in N2).

### Beispiel 2a: Lanthancerat Doppelbeschichtung

Ein Teil der Beschichtung aus Beispiel 2 wurde erneut nach exakt demselben Verfahren ein zweites Mal beschichtet, getrocknet und unter Formiergas kristallisiert.

### Beispiel 3: Lanthancerat

Lanthanpropionat, Cerpropionat und Kupferpropionat werden im molaren Verhältnis 9:9:1 so in Propionsäure gelöst, dass eine 0,4 molare Lösung in Bezug auf Lanthan entsteht.

Die Lösung wird gemäß der allgemeinen Versuchsbeschreibung unmittelbar auf ein Metallsubstratband aufgebracht. Die Trocknung erfolgt innerhalb von 10min bei 120°C unter Luft, die Glühbehandlung erfolgt innerhalb von 20min bei 950°C unter Formiergas (5%H2 in N2).

### Beispiel 4: Lanthanzirkonat (Vergleichsbeispiel)

Lanthanpropionat, Zirkonpropionat und Kupferpropionat werden im molaren Verhältnis 9:9:1 so in Propionsäure gelöst, dass eine 0,4 molare Lösung in Bezug auf Lanthan entsteht.

Die Lösung wird gemäß der allgemeinen Versuchsbeschreibung unmittelbar auf ein Metallsubstratband aufgebracht. Die Trocknung erfolgt innerhalb von 10min bei 120°C unter Luft, die Glühbehandlung erfolgt innerhalb von 20min bei 1000°C unter Formiergas (5%H2 in N2).

### Beispiel 4a: Lanthanzirkonat Doppelbeschichtung (Vergleichsbeispiel)

Ein Teil der Beschichtung aus Beispiel 5 wurde erneut nach exakt demselben Verfahren ein zweites Mal beschichtet, getrocknet und kristallisiert.

Alle Pufferschichten wurden anschließend mit einer Standard-HTS Schicht beschichtet. Hierzu wurde eine Lösung von Yttrium-, Barium- und Kupfer-Trifluoracetat (Metallverhältnis 1:2:3) in wasserfreiem Methanol hergestellt. Die Beschichtung erfolgte in einer kontinuierlichen Beschichtungsanlage mit einer Zuggeschwindigkeit von 8m/h. Die Trocknung erfolgte innerhalb von 30min an Luft, gefolgt von einer Pyrolyse bei Temperaturen von 190-400°C innerhalb von 2h (Luft, Taupunkt 20°C). Die Reaktion und Kristallisation erfolgte innerhalb von 1h zwischen 400 und 790°C bzw. innerhalb 1h bei 790°C (100ppm Sauerstoff in Stickstoff, Taupunkt 20°C). Nach einer Sauerstoffbeladung (450°C, 1h, 100% Sauerstoff) erfolgt die Abkühlung und Messung der kritischen Supraleitenden Parameter in einer induktiven Messanlage (Cryoscan, Fa. THEVA). Bestimmt wurde die kritische Stromdichte bei einer Schichtdicke der supraleitenden Schicht von 280nm.

| Versuchsnr. | Kritische Stromdichte [MA/cm²] |
|---|---|
| 1 | 0,2 |
| 1a | 1,5 |
| 2 | 0,1 |
| 2a | 0,1 |
| 3 | 0,5 |
| 4 | 0 |
| 4a | 0 |

## Patentansprüche

1. Hochtemperatursupraleiter-Schichtanordnung umfassend mindestens ein Trägermaterial und eine texturierte Pufferschicht aus oxidischen Material, die ein texturiertes Aufwachsen eines Hochtemperatursupraleiters ermöglicht, **dadurch gekennzeichnet, dass** zumindest eine Schicht des Puffermaterials aus einem Seltenerdenmetall-Cer-Oxid besteht, wobei als Seltenerdenmetall Lanthan enthalten ist und in welchem bezogen auf den Gesamtmetallgehalt der Cer-Gehalt zwischen 5 at.-% und 95 at.-% Ce und der Gehalt der von Cer verschiedenen Seltenerdenmetalle RE zwischen 95 at.-% und 5 at.-% beträgt.

2. Schichtanordnung nach Anspruch 1, **dadurch gekennzeichnet, dass** als Seltenerdenmetall weiterhin eines oder mehrere Metalle aus der Gruppe Nd, Sm, Eu, Gd, Y, Yb enthalten sind.

3. Schichtanordnung nach Anspruch 1 oder 2, **dadurch gekennzeichnet, das** Pufferschichtmaterial ein Seltenerdenoxid der allgemeinen Formel RE₂₊ₓCe_{z+y}O_{z} mit -2 < x, y < 2, ist, wobei RE eines oder mehrere Seltenerdenmetalle sind und z die neutrale Ladungsbilanz sicherstellt.

4. Schichtanordnung nach einem der Ansprüche 1 bis 3, **dadurch gekennzeichnet, dass** das Seltenerdmetall und/oder Cer teilweise durch eines oder mehrere Metalle ausgewählt aus der Gruppe Hf, Ta, Zr, Pb, Nb substituiert ist.

5. Schichtanordnung nach einem der Ansprüche 1 bis 4, **dadurch gekennzeichnet, dass** das Seltenerdenmetall-Cer-Oxid bezogen auf den Gesamtmetallgehalt ≥ 25 at.-% Ce und/oder ≥ 25 at.-% La enthält.

6. Schichtanordnung nach einem der Ansprüche 1 bis 5, **dadurch gekennzeichnet, dass** Seltenerdenmetall-Cer-Oxid im Fluorittyp kristallisiert.

7. Schichtanordnung nach einem der Ansprüche 1 bis 6, **dadurch gekennzeichnet, dass** das Pufferschichtmaterial mindestens einen weiteren, eine homogene Mischkristallphase bildenden Bestandteil enthält, der ein Übergangsmetall der ersten Nebengruppe ist und/oder der bei einer Glühtemperatur von ≤ 1.250-1.600 Grad Celsius mit dem oxidischen Puffermaterial zumindest eine partielle Schmelze bildet.

8. Schichtanordnung nach Anspruch 7, **dadurch gekennzeichnet, dass** das Übergangsmetall Kupfer und/oder Silber ist.

9. Schichtanordnung nach Anspruch 7 oder 8, **dadurch gekennzeichnet, dass** der weitere Bestandteil in einem Gehalt von bis zu 40 at.-% bezogen auf den Gesamtmetallgehalt der Pufferschicht vorliegt.

10. Schichtanordnung nach einem der Ansprüche 1 bis 9, **dadurch gekennzeichnet, dass** die zwischen Trägermaterial und HTSL-Schicht angeordnete Pufferschicht zwei oder mehr Schichten aufweist, die jeweils aus einem - gegebenenfalls voneinander verschiedenen - Seltenerdenmetall-Cer-Oxid bestehen, oder dass die Pufferschicht nur einschichtig ausgebildet ist.

11. Schichtanordnung nach einem der Ansprüche 1 bis 10, **dadurch gekennzeichnet, dass** die Pufferschicht nur aus Schichten besteht, die einen weiteren, eine homogene Mischkristallphase bildenden weiteren Bestandteil aufweist.

12. Verfahren zur Herstellung einer Hochtemperatursupraleiter-Schichtanordnung nach einem der Ansprüche 1 bis 11, wobei auf einem Trägermaterial eine texturierte Pufferschicht aufgebracht wird, die ein texturiertes Aufwachsen eines Hochtemperatursupraleiters ermöglicht, **dadurch gekennzeichnet, dass** zumindest eine Schicht des Puffermaterials aus einem Seltenerdenmetall-Cer-Oxid erzeugt wird, wobei als Seltenerdenmetall Lanthan eingesetzt wird und in welchem bezogen auf den Gesamtmetallgehalt der Cer-Gehalt zwischen 5 at.-% und 95 at.-% Ce beträgt.

13. Verfahren nach Anspruch 12, **dadurch gekennzeichnet, dass** die Pufferschicht derart hergestellt wird, dass das Seltenerdenmetall und/oder Cer teilweise substituiert ist.

14. Verfahren nach Anspruch 12 oder 13, **dadurch gekennzeichnet, das** Pufferschichtmaterial als ein Seltenerdenoxid der allgemeinen Formel RE₂₋ₓCe_{2-y}O_{7±2z}, mit 0 ≤ x, y, z ≤ 1 hergestellt wird, wobei RE eines oder mehrere Seltenerdenmetalle sind und wobei RE und/oder Ce teilweise substituiert sein können.

15. Verfahren nach einem der Ansprüche 12 bis 14, **dadurch gekennzeichnet, dass** die das Seltenerdenmetall-Cer-Oxid enthaltende Pufferschicht unmittelbar auf dem Trägermaterial aufgebracht wird und/oder als die Substratschicht gebildet wird, auf welcher die HTSL-Schicht aufgebracht wird.

16. Verfahren nach einem der Ansprüche 12 bis 15, **dadurch gekennzeichnet, dass** die Pufferschicht durch chemische Lösungsbeschichtung (CSD) hergestellt wird.

17. Verfahren nach einem der Ansprüche 12 bis 16, **dadurch gekennzeichnet, dass** die das Seltenerdenmetall-Cer-Oxid enthaltende, unmittelbar auf das Trägermaterial aufgebrachte Pufferschicht unter einer Glühbehandlung hergestellt wird und dass die Glühbehandlung in einer nichtreduzierenden Atmosphäre erfolgt.

18. Verfahren nach einem der Ansprüche 12 bis 17, **dadurch gekennzeichnet, dass** die das Seltenerdenmetall-Cer-Oxid enthaltende Pufferschicht, auf eine zwischen dieser und dem Trägermaterial angeordnete Zwischenschicht aus Puffermaterial aufgebracht wird, und dass die Pufferschicht unter einer Glühbehandlung in einer reduzierenden Atmosphäre hergestellt wird.

19. Verfahren nach einem der Ansprüche 12 bis 18, **dadurch gekennzeichnet, dass** die Pufferschicht und/oder die auf diese aufgebrachte HTSL-Schicht derart erzeugt wird, dass diese eine kritische Stromdichte von ≥ 0,5 MA/cm² aufweist.

20. Verfahren nach einem der Ansprüche 12 bis 19, **dadurch gekennzeichnet, dass** die Pufferschicht derart erzeugt wird, dass diese eine Porosität von ≤ 25% und/oder eine RMS-Rauheit von ≤ 1,8 nm aufweist.
